# EUROPEAN PATENT APPLICATION

(11) **EP 4 242 674 A1**
(43) Date of publication of application: **13.09.2023**
(21) Application number: 21888866.7
(22) Date of filing: 11.03.2021
(51) Int. Cl.: G01R 31/34, G01R 31/52, G01R 31/56

(54) **INSULATION RESISTANCE MONITORING DEVICE**

(30) Priority: 09.11.2020 JP 2020186627
(71) Applicant: OMRON Corporation, Kyoto 600-8530 (JP)
(72) Inventor: YAMAGUCHI, Shohei, Kyoto-shi, Kyoto 600-8530 (JP); OZAKI, Masahiro, Kyoto-shi, Kyoto 600-8530 (JP); TAKATANI, Ryohei, Kyoto-shi, Kyoto 600-8530 (JP)
(74) Representative: HGF
(86) International application number: PCT/JP2021/009904
(87) International publication number: WO 2022/097312

(57) **Abstract**

A voltage source (E1) applies a voltage between two nodes of an object to be measured, the two nodes being insulated from each other. A current measuring device (41) measures a capacitive leakage current (Ioc) between the two nodes of the object to be measured. A switch (SW) opens and closes a circuit between the object to be measured and the voltage source (E1). A controller (43) determines whether or not the switch (SW) normally operates, based on the measured capacitive leakage current (Ioc).

## Description

### TECHNICAL FIELD

The present disclosure relates to an insulation resistance monitoring apparatus.

### BACKGROUND ART

Electricity facilities, such as high-voltage substations and distribution boards, are required by the Electricity Business Act to be mandatorily inspected at a frequency of about once a year. In addition, electric apparatuses connected to a distribution board, such as a motor, are also voluntarily inspected by a company at a frequency of about once a week to once a month, according to the company's own management standard.

However, target objects of voluntary inspection (objects to be measured) include a wide variety of electric facilities and electric apparatuses, and in fact, there are too many objects to actually conduct the measurement. Therefore, an insulation resistance monitoring apparatus has been developed for automating the voluntary inspection.

For example, Patent Document 1 discloses an insulation resistance monitoring apparatus provided with a switch for opening and closing a connection path between a power supply wire or a ground wire of a object to be measured, and a voltage source of the insulation resistance monitoring apparatus. The switch has an off-resistance of, for example, 100 megohms or more. When the insulation resistance of the object to be measured, to which the insulation resistance monitoring apparatus is connected, is measured for, for example, mandatory inspection, using an insulation resistance measuring device other than the insulation resistance monitoring apparatus, an unnecessary current flows from the insulation resistance measuring device to the insulation resistance monitoring apparatus, and the insulation resistance may not be accurately measured. According to the insulation resistance monitoring apparatus of Patent Document 1, by turning off the switch, it is possible to prevent an unnecessary current flowing from the insulation resistance measuring device to the insulation resistance monitoring apparatus. Therefore, it is possible to measure the insulation resistance of the object to be measured, using the insulation resistance measuring device, without detaching the insulation resistance monitoring apparatus from the object to be measured.

### CITATION LIST

### PATENT DOCUMENTS

PATENT DOCUMENT 1: Japanese Patent Laid-open Publication JP 2020-148736 A

### SUMMARY OF INVENTION

### TECHNICAL PROBLEM

In the insulation resistance monitoring apparatus of Patent Document 1, when the switch is in a stuck-open fault, the apparent insulation resistance of the object to be measured by the insulation resistance monitoring apparatus increases, and it is not possible to measure the actual insulation resistance of the object to be measured. Therefore, it is required to be capable of determining whether or not the switch of the insulation resistance monitoring apparatus normally operates.

An object of the present disclosure is to provide an insulation resistance monitoring apparatus provided with a switch for opening and closing a circuit between an object to be measured and an internal voltage source, the insulation resistance monitoring apparatus being capable of determining whether or not the switch normally operates.

### SOLUTION TO PROBLEM

An insulation resistance monitoring apparatus according to one aspect of the present invention monitors an insulation resistance of an object to be measured, the insulation resistance monitoring apparatus is provided with: a voltage source, a first current measuring device, a switch configured, and a controller. The voltage source is configured to apply a voltage between two nodes of the object to be measured, the two nodes being insulated from each other. The first current measuring device is configured to measure a capacitive leakage current between the two nodes of the object to be measured. The switch is configured to open and close a circuit between the object to be measured and the voltage source. The controller is configured to determine whether or not the switch normally operates, based on the measured capacitive leakage current.

With such a configuration, it is possible to determine whether or not the switch of the insulation resistance monitoring apparatus normally operates.

According to the insulation resistance monitoring apparatus of one aspect of the present invention, when the measured capacitive leakage current increases to exceed a threshold immediately after turning on the switch, and decreases below the threshold within a predetermined time period after exceeding the threshold, the controller is further configured to determine that the switch normally operates. When the measured capacitive leakage current does not exceed the threshold immediately after turning on the switch, the controller is further configured to determine that the switch malfunctions.

With such a configuration, it is possible to determine whether or not the switch normally operates.

According to the insulation resistance monitoring apparatus of one aspect of the present invention, when an event that the measured capacitive leakage current does not exceed the threshold immediately after turning on the switch occurs consecutively for a predetermined number of times, the controller is further configured to determine that the switch malfunctions.

With such a configuration, erroneous detection caused by noise or a disturbance factor can be made less likely to occur.

According to the insulation resistance monitoring apparatus of one aspect of the present invention, the controller is further configured to stop calculation of the insulation resistance of the object to be measured, when determining that the switch malfunctions.

With such a configuration, it is possible to calculate the insulation resistance of the object to be measured, only when the switch normally operates.

According to the insulation resistance monitoring apparatus of one aspect of the present invention, the switch has an open resistance of 100 megohms or more.

With such a configuration, it is possible to measure the insulation resistance of the object to be measured, using an insulation resistance measuring device other than the insulation resistance monitoring apparatus, without detaching the insulation resistance monitoring apparatus from the object to be measured.

According to the insulation resistance monitoring apparatus of one aspect of the present invention, the two nodes of the object to be measured includes a first node connected to a power line of the object to be measured, and a second node connected to a ground conductor.

With such a configuration, it is possible to measure a line-to-ground insulation resistance between the power line and the ground conductor of the object to be measured.

According to the insulation resistance monitoring apparatus of one aspect of the present invention, the insulation resistance monitoring apparatus is further provided with a second current measuring device configured to measure a resistive leakage current between the two nodes of the object to be measured. The controller calculates an insulation resistance of the object to be measured, based on the measured resistive leakage current.

With such a configuration, it is possible to monitor the insulation resistance of the object to be measured.

According to the insulation resistance monitoring apparatus of one aspect of the present invention, the insulation resistance monitoring apparatus is further provided with an output device configured to provide notification of the insulation resistance of the object to be measured, and whether or not the switch normally operates.

With such a configuration, the user can determine whether or not to conduct maintenance of the object to be measured and the insulation resistance monitoring apparatus.

### ADVANTAGEOUS EFFECTS OF INVENTION

According to the insulation resistance monitoring apparatus of one aspect of the present invention, it is possible to determine whether or not the switch of the insulation resistance monitoring apparatus normally operates.

### BRIEF DESCRIPTION OF DRAWINGS

Fig. 1 is a block diagram showing a configuration of a motor system including an insulation resistance monitoring apparatus 40 according to an embodiment.
Fig. 2 is a diagram for explaining a capacitive leakage current Ioc flowing through a three-phase motor apparatus 30 of Fig. 1.
Fig. 3 is a graph showing a waveform of the capacitive leakage current Ioc flowing through the three-phase motor apparatus 30 of Fig. 1.
Fig. 4 is a diagram for explaining a resistive leakage current Ior flowing through the three-phase motor apparatus 30 of Fig. 1.
Fig. 5 is a graph showing a waveform of the resistive leakage current Ior flowing through the three-phase motor apparatus 30 of Fig. 1.
Fig. 6 is a flowchart showing an insulation resistance monitoring process executed by a controller 43 in Fig. 1.
Fig. 7 is a flowchart showing a modification of the insulation resistance monitoring process executed by the controller 43 in Fig. 1.

### DESCRIPTION OF EMBODIMENTS

Hereinafter, an embodiment according to one aspect of the present disclosure will be described with reference to the drawings. In the drawings, the same reference signs denote similar components.

### [EMBODIMENT]

Hereinafter, an insulation resistance monitoring apparatus according to the embodiment will be further described.

### [CONFIGURATION EXAMPLE OF EMBODIMENT]

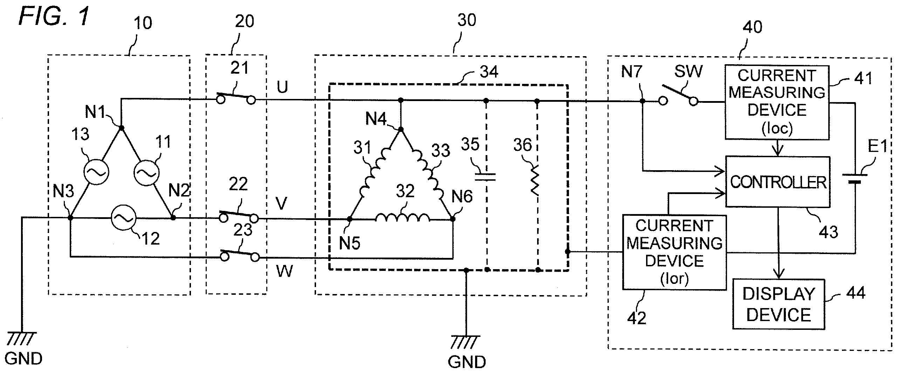

Fig. 1 is a block diagram showing a configuration of a motor system including an insulation resistance monitoring apparatus 40 according to the embodiment. The motor system of Fig. 1 is provided with a three-phase AC power supply apparatus 10, a circuit breaker 20, a three-phase motor apparatus 30, and an insulation resistance monitoring apparatus 40. The example of Fig. 1 shows a case where the insulation resistance monitoring apparatus 40 measures the insulation resistance of the three-phase motor apparatus 30, as an object to be measured.

The three-phase AC power supply apparatus 10 is provided with three single-phase AC power sources 11 to 13. The single-phase AC power sources 11 to 13 generate single-phase AC voltages having phases different from each other by 120 degrees. In the example of Fig. 1, the single-phase AC power sources 11 to 13 are connected to each other in a delta configuration. Nodes N1 to N3 connect the single-phase AC power sources 11 to 13 to each other, and the nodes N1 to N3 are further connected to the circuit breaker 20 and the three-phase motor apparatus 30 via U-phase, V-phase, and W-phase power lines.

The three-phase AC power supply apparatus 10 may include a distribution board, a high-voltage substation, and the like. In this case, the high-voltage substation reduces a higher voltage supplied from a power company, for example, 6600 V, to a lower voltage, for example, about 200 V to 480 V. The distribution board distributes the reduced voltage to the three-phase motor apparatus 30 and other load apparatuses.

The circuit breaker 20 includes switches 21 to 23 inserted into the U-phase, V-phase, and W-phase power lines, respectively.

The three-phase motor apparatus 30 is provided with windings 31 to 33 and a housing 34. In the example of Fig. 1, the windings 31 to 33 are connected to each other in a delta configuration. Nodes N4 to N6 connect the windings 31 to 33 to each other, and the nodes N4 to N6 are further connected to the U-phase, V-phase, and W-phase power lines, respectively. The housing 34 is another node that is electrically insulated from the windings 31 to 33. The housing 34 may be grounded.

A leakage current may flow between the windings 31 to 33 and the housing 34. The example of Fig. 1 shows a case where a line-to-ground insulation resistance 36 through which a resistive leakage current flows, and a line-to-ground capacitance 35 through which a capacitive leakage current flows occur between the node N4 and the housing 34. The line-to-ground insulation resistance 36 has an insulation resistance value Ro.

The insulation resistance monitoring apparatus 40 is provided with a current measuring device 41, a current measuring device 42, a controller 43, a display device 44, a voltage source El, and a switch SW.

The voltage source El supplies a voltage to be applied between two nodes of the three-phase motor apparatus 30, the two nodes being insulated from each other, that is, between the node N4 and the housing 34 in the example of Fig. 1. The voltage source E1 supplies, for example, a DC voltage of 50 V.

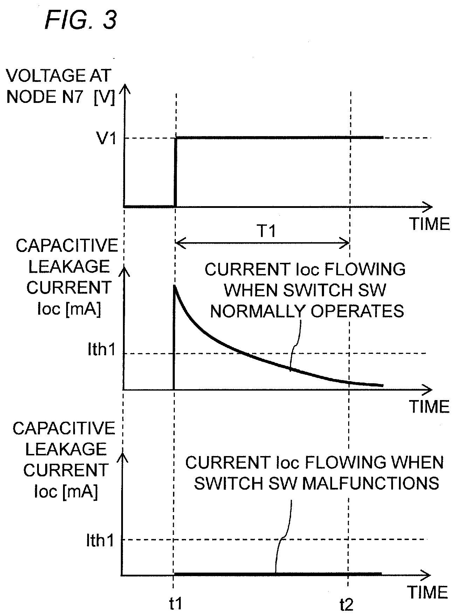

The current measuring device 41 measures a capacitive leakage current Ioc between the node N4 and the housing 34 of the three-phase motor apparatus 30. The capacitive leakage current Ioc flows through the line-to-ground capacitance 35 due to the voltage supplied by the voltage source E1, and charges the line-to-ground capacitance 35. As will be described later with reference to Fig. 3, when a current occurs with such a waveform that some capacitance is charged, it is judged that the capacitive leakage current Ioc flows through the line-to-ground capacitance 35. The current measuring device 42 is provided with operational amplifiers and others, and is configured to measure a current of the order of, for example, several milliamperes to several tens of milliamperes.

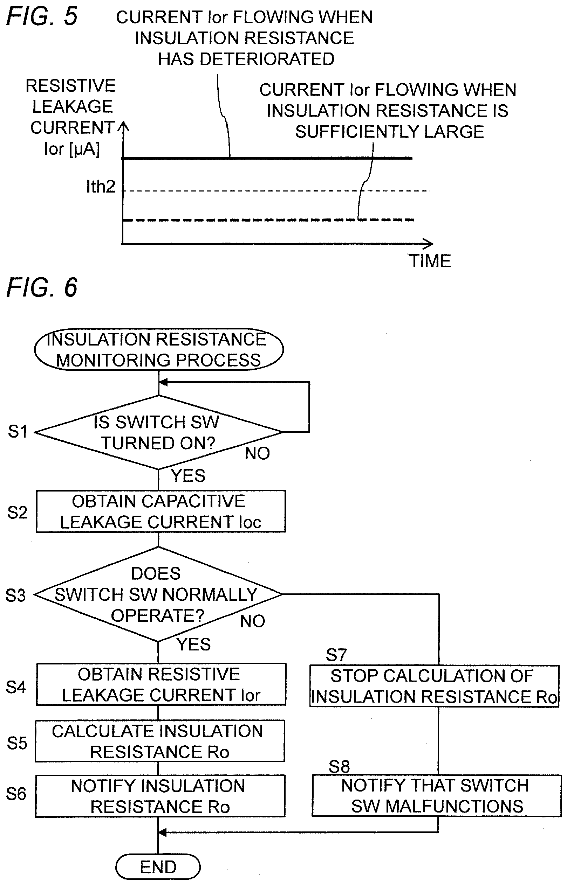

The current measuring device 42 measures a resistive leakage current Ior between the node N4 and the housing 34 of the three-phase motor apparatus 30. The resistive leakage current Ior flows through the line-to-ground insulation resistance 36 due to the voltage supplied by the voltage source E1. As will be described later with reference to Fig. 5, when a current occurs with a flat waveform, it is judged that the resistive leakage current Ior flows through the line-to-ground insulation resistance 36. The current measuring device 42 is provided with operational amplifiers and others, and is configured to measure a current of the order of, for example, several microamperes to several tens of microamperes.

The switch SW opens and closes a circuit between the three-phase motor apparatus 30 and the voltage source E1. In the example of Fig. 1, the switch SW is inserted between the node N4 and the voltage source E1, but may be inserted at other positions. The switch SW may be, for example, a mechanical switch operated by a user, or may be a reed relay operable according to an external control signal. The open resistance of the switch SW is set according to a desired insulation resistance of the object to be measured. For example, in a case where the insulation resistance of the three-phase motor apparatus 30 is about 100 megohms, the switch SW has an open resistance of 100 megohms or more, preferably 1000 megohms or more.

The controller 43 determines whether or not the switch SW is turned on, by detecting the voltage potential of the node N7 connected to the voltage source E1 via the switch SW. When the switch SW is turned on, the controller 43 determines whether or not the switch SW normally operates, based on the capacitive leakage current Ioc, and further calculates the insulation resistance value Ro of the three-phase motor apparatus 30, based on the resistive leakage current Ior. In the present embodiment, it is assumed that the switch SW may be broken and stuck open. The controller 43 may determine whether or not the insulation resistance value Ro satisfies mandatory requirements. The controller 43 outputs the determined result and the calculated result to the display device 44.

The display device 44 provides notification of the insulation resistance value Ro of the three-phase motor apparatus 30, and whether or not the switch SW normally operates. In addition to or instead of the insulation resistance value Ro, the display device 44 may display whether or not the insulation resistance value Ro satisfies mandated requirements.

When the user turns on the switch SW, the insulation resistance monitoring apparatus 40 can determine whether or not the switch SW normally operates, and when the switch SW normally operates, the insulation resistance monitoring apparatus 40 measures the insulation resistance value Ro of the three-phase motor apparatus 30. In addition, when the insulation resistance of the three-phase motor apparatus 30 is measured for, for example, mandatory inspection, using an insulation resistance measuring device other than the insulation resistance monitoring apparatus 40, the user turns off the circuit breaker 20 and the switch SW, and connects probes of the insulation resistance measuring device to two nodes of the three-phase motor apparatus 30, the two nodes being insulated from each other (for example, the node N4 and the housing 34). As a result, it is possible to measure the insulation resistance of the three-phase motor apparatus 30 using the insulation resistance measuring device, without detaching the insulation resistance monitoring apparatus 40 from the three-phase motor apparatus 30.

### [OPERATION EXAMPLE OF EMBODIMENT]

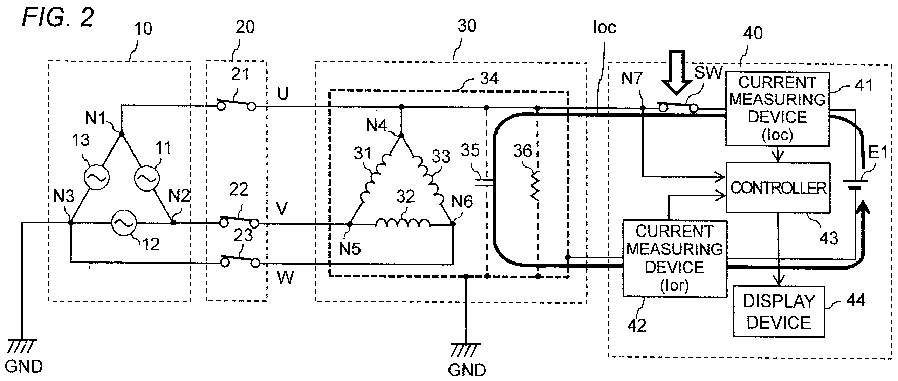

Fig. 2 is a diagram for explaining the capacitive leakage current Ioc flowing through the three-phase motor apparatus 30 of Fig. 1. Fig. 3 is a graph showing a waveform of the capacitive leakage current Ioc flowing through the three-phase motor apparatus 30 of Fig. 1. When the switch SW is turned on, the capacitive leakage current Ioc flows through the line-to-ground capacitance 35 to charge the line-to-ground capacitance 35, as described above. When the switch SW is turned on, the voltage potential of the node N7 transitions from 0 to V1 as shown in the top of Fig. 3. As shown in the middle of Fig. 3, when the capacitive leakage current Ioc increases to exceed a threshold Ith1 immediately after turning on the switch SW, and decreases below the threshold Ith1 within a predetermined time period T1 after exceeding the threshold Ith1, the controller 43 determines that the switch SW normally operates. The waveform in the middle of Fig. 3 indicates that since the switch SW is turned on, a current flows through the line-to-ground capacitance 35 to charge the line-to-ground capacitance 35. On the other hand, as shown in the bottom of Fig. 3, when the capacitive leakage current Ioc does not exceed the threshold Ith1 immediately after turning on the switch SW, the controller 43 determines that the switch SW malfunctions. In addition, when the capacitive leakage current Ioc increases to exceed the threshold Ith1 immediately after turning on the switch SW, and remains above the threshold Ith1 after the time period T1 elapses, the controller 43 determines that the switch SW or other component(s) malfunctions. For example, when the three-phase motor apparatus 30 has the rated output of 2.2 kW, and the voltage source E1 supplies a voltage of 50 V, the threshold Ith1 is set to the order of several milliamperes to several tens of milliamperes (for example, 2.5 milliamperes). In general, the line-to-ground capacitance 35 increases in proportion to the rated output of the three-phase motor apparatus 30, and thus, the threshold Ith1 also increases in proportion to the rated output of the three-phase motor apparatus 30. In this case, the time period T1 is set to, for example, 30 milliseconds. The length of the time period T1 is set according to the charging time of the line-to-ground capacitance 35, that is, the magnitude of the line-to-ground capacitance 35, and the voltage supplied by the voltage source E1.

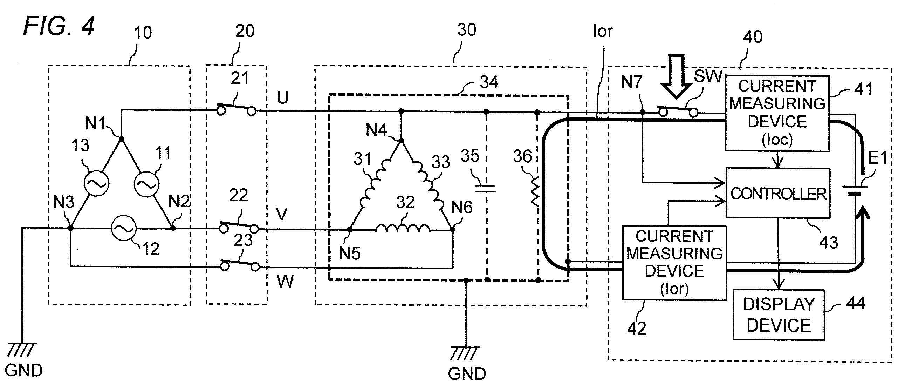

Fig. 4 is a diagram for explaining the resistive leakage current Ior flowing through the three-phase motor apparatus 30 of Fig. 1. Fig. 5 is a graph showing a waveform of the resistive leakage current Ior flowing through the three-phase motor apparatus 30 of Fig. 1. The resistive leakage current Ior flows through the line-to-ground insulation resistance 36, as described above. When there is the line-to-ground insulation resistance 36, a current occurs with a flat waveform as indicated by a solid line or a broken line in Fig. 3. After sufficient time has elapsed from when the switch SW is turned on and the capacitive leakage current Ioc increases and decreases (see the middle of Fig. 3), the controller 43 calculates the insulation resistance value Ro of the three-phase motor apparatus 30, based on the voltage supplied by the voltage source E1, and the resistive leakage current Ior measured by the current measuring device 42. As indicated by a solid line in Fig. 5, when the resistive leakage current Ior exceeds the threshold Ith2, the controller 43 may determine that the insulation resistance deteriorates, and the insulation resistance value Ro does not satisfy mandatory requirements. In addition, as indicated by a broken line in Fig. 5, when the resistive leakage current Ior is smaller than the threshold Ith2, the controller 43 may determine that the insulation resistance is sufficiently large, and the insulation resistance value Ro satisfies mandatory requirements. For example, when the three-phase motor apparatus 30 has the rated output of 2.2 kW, and the voltage source E1 supplies a voltage of 50 V, the threshold Ith2 is set to the order of several microamperes to several tens of microamperes.

The controller 43 may determine whether or not the insulation resistance value Ro satisfies mandatory requirements, by comparing the calculated insulation resistance value Ro with the threshold resistance, instead of comparing the resistive leakage current Ior with the threshold Ith2.

Fig. 6 is a flowchart showing an insulation resistance monitoring process executed by the controller 43 in Fig. 1.

In step S1, the controller 43 determines whether or not the switch SW is turned on: if YES, the process proceeds to step S2; if NO, the process repeats step S1.

In step S2, the controller 43 obtains the capacitive leakage current Ioc from the current measuring device 41.

In step S3, the controller 43 determines whether or not the switch SW normally operates, based on the capacitive leakage current Ioc: if YES, the process proceeds to step S4; if NO, the process proceeds to step S7.

In step S4, the controller 43 obtains the resistive leakage current Ior from the current measuring device 42.

In step S5, the controller 43 calculates the insulation resistance value Ro of the three-phase motor apparatus 30, based on the voltage supplied by the voltage source E1, and the resistive leakage current Ior measured by the current measuring device 42.

In step S6, the controller 43 outputs the calculated insulation resistance value Ro to the display device 44 to notify the user thereof. In addition to or instead of notifying the user of the insulation resistance value Ro, the controller 43 may output, to the display device 44, whether or not the insulation resistance value Ro satisfies mandatory requirements, to notify the user thereof. By notifying the user of the insulation resistance value Ro (alternatively, whether or not the insulation resistance value Ro satisfies mandatory requirements), it can be seen that the switch SW normally operates.

In step S7, the controller 43 stops the calculation of the insulation resistance value Ro.

In step S8, the controller 43 outputs the fact that the switch SW malfunctions, to the display device 44, to notify the user thereof. When it is determined that the switch SW malfunctions, the controller 43 stops the calculation of the insulation resistance value Ro of the three-phase motor apparatus 30.

Once it is determined that the switch SW normally operates (YES in step S3), the controller 43 may then periodically repeat steps S4 to S6.

According to the process of Fig. 6, when the user turns on the switch SW, the controller 43 can determine whether or not the switch SW normally operates, based on the capacitive leakage current Ioc. In addition, when the switch SW normally operates, the controller 43 can calculate the insulation resistance value Ro of the three-phase motor apparatus 30, based on the resistive leakage current Ior.

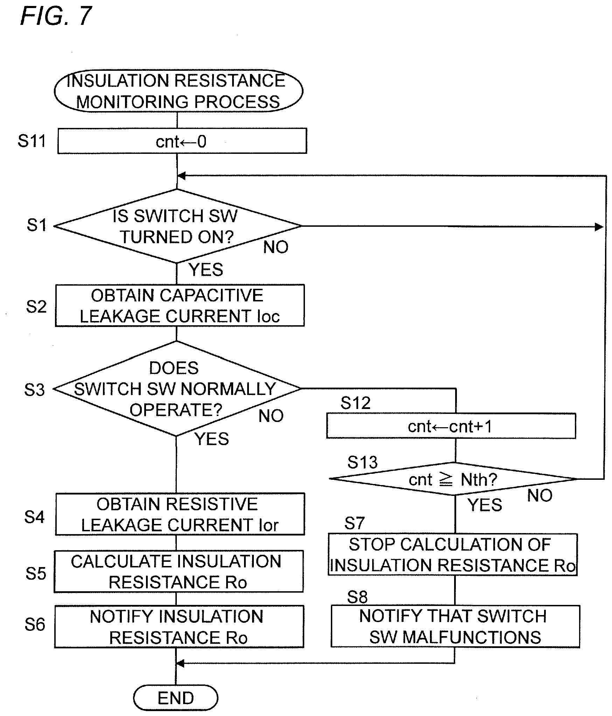

Fig. 7 is a flowchart showing a modification of the insulation resistance monitoring process executed by the controller 43 in Fig. 1. The process of Fig. 7 further includes steps S11 to S13, in addition to the steps of Fig. 6.

In step S11, the controller 43 initializes the parameter cnt to 0, the parameter ent counting the number of times determined NO in step S3.

In the process of Fig. 7, if NO in step S3, the process proceeds to step S12 instead of step S7.

In step S12, the controller 43 increments the parameter cnt by 1.

In step S13, the controller 43 determines whether or not the parameter ent is greater than or equal to the threshold Nth: if YES, the process proceeds to step S7; if NO, the process returns to step S1.

According to the process of Fig. 7, when an event that the capacitive leakage current Ioc does not exceed the threshold Ith1 immediately after turning on the switch SW occurs consecutively for a predetermined number of times, the controller 43 determines that the switch SW malfunctions. As a result, erroneous detection caused by noise or a disturbance factor can be made less likely to occur.

### [ADVANTAGEOUS EFFECTS OF EMBODIMENT]

When the user turns on the switch SW, the insulation resistance monitoring apparatus 40 according to the embodiment can determine whether or not the switch SW normally operates, and when the switch SW normally operates, the insulation resistance monitoring apparatus 40 can measure the insulation resistance value Ro of the three-phase motor apparatus 30. According to the present embodiment, even if the switch SW is broken and stuck open, it is possible to prevent erroneous determination that the insulation resistance value Ro satisfies mandatory requirements, and accurately monitor the insulation resistance value Ro.

According to the conventional method of measuring the insulation resistance, it is commonly considered that the capacitive leakage current disturbs the measurement, and therefore, the capacitive leakage is handled so as not to be reflected in the calculation result of the insulation resistance. On the other hand, according to the present embodiment, a novel technique is proposed for determining whether or not the switch SW normally operates, based on the capacitive leakage current Ioc, and thus, it is possible to accurately monitor the insulation resistance value Ro.

### [OTHER EMBODIMENTS]

Although the embodiment of the present disclosure has been described in detail above, the above description is a mere example of the present disclosure in all respects. Needless to say, various improvements and modifications can be made without departing from the scope of the present disclosure. For example, the following changes can be made. Hereinafter, components similar to those of the above embodiment are indicated by similar reference signs, and points similar to those of the above embodiment will be omitted as appropriate. The following modified embodiments can be combined as appropriate.

According to the embodiment described above, the insulation resistance monitoring apparatus 40 is connected to the node N4 and the housing 34 of the three-phase motor apparatus 30. However, the insulation resistance monitoring apparatus 40 may be connected between the node N5 and the housing 34, or may be connected between the node N6 and the housing 34.

The insulation resistance monitoring apparatus 40 may be connected between two nodes of any other object to be measured, instead of the three-phase motor apparatus 30, the two nodes being insulated from each other. The object to be measured includes, for example, a power supply apparatus, a timer, a relay, a common socket, a DIN rail, a waterproof cover, a temperature regulator, a switch, and the like. In addition, the insulation resistance monitoring apparatus 40 may be connected to any two nodes of the object to be measured, the two nodes being insulated from each other, as well as the power line and the ground conductor of the object to be measured.

The display device 44 may be provided in a remote device connected via a communication line, instead of the inside of the insulation resistance monitoring apparatus 40.

The determination result and the calculation result of the controller 43 may be audibly outputted using an audio output device, instead of being visually outputted using the display device 44. In addition, any other output device may be used to notify the user of the determination result and the calculation result of the controller 43. In addition, the insulation resistance monitoring apparatus 40 may output the determination result and the calculation result of the controller 43 to other device(s) connected via a communication line.

It is possible to selectively configure whether to notify the user of the determination result and the calculation result of the controller 43, or to stop the measurement of the insulation resistance value Ro. Thus, it is possible to improve usability of the insulation resistance monitoring apparatus 40.

### [SUMMARY]

The insulation resistance monitoring apparatuses according to aspects of the present disclosure may be expressed as follows.

The insulation resistance monitoring apparatuses according to one aspect of the present disclosure is provided with a voltage source El, a first current measuring device 41, a switch SW configured, and a controller 43, and the insulation resistance monitoring apparatus 40 monitors an insulation resistance value Ro of an object to be measured. The voltage source E1 is configured to apply a voltage between two nodes of the object to be measured, the two nodes being insulated from each other. The first current measuring device 41 is configured to measure a capacitive leakage current Ioc between the two nodes of the object to be measured. The switch SW is configured to open and close a circuit between the object to be measured and the voltage source E1. The controller 43 is configured to determine whether or not the switch SW normally operates, based on the measured capacitive leakage current Ioc.

According to the insulation resistance monitoring apparatuses of one aspect of the present disclosure, when the measured capacitive leakage current Ioc increases to exceed a threshold Ith1 immediately after turning on the switch SW, and decreases below the threshold Ith1 within a predetermined time period T1 after exceeding the threshold Ith1, the controller 43 may determine that the switch SW normally operates. In addition, when the measured capacitive leakage current Ioc does not exceed the threshold Ith1 immediately after turning on the switch SW, the controller 43 may determine that the switch SW malfunctions.

According to the insulation resistance monitoring apparatuses of one aspect of the present disclosure, when an event that the measured capacitive leakage current Ioc does not exceed the threshold Ith1 immediately after turning on the switch SW occurs consecutively for a predetermined number of times, the controller 43 may determine that the switch SW malfunctions.

According to the insulation resistance monitoring apparatuses of one aspect of the present disclosure, the controller 43 may stop calculation of the insulation resistance value Ro of the object to be measured, when determining that the switch SW malfunctions.

According to the insulation resistance monitoring apparatuses of one aspect of the present disclosure, the switch SW may have an open resistance of 100 megohms or more.

According to the insulation resistance monitoring apparatuses of one aspect of the present disclosure, the two nodes of the object to be measured may include a first node connected to a power line of the object to be measured, and a second node connected to a ground conductor.

According to the insulation resistance monitoring apparatuses of one aspect of the present disclosure, the insulation resistance monitoring apparatus 40 may be further provided with a second current measuring device 42 configured to measure a resistive leakage current Ior between the two nodes of the object to be measured. The controller 43 calculates an insulation resistance Ro of the object to be measured, based on the measured resistive leakage current Ior.

According to the insulation resistance monitoring apparatuses of one aspect of the present disclosure, the insulation resistance monitoring apparatus 40 may be further provided with an output device configured to provide notification of the insulation resistance of the object to be measured, and whether or not the switch SW normally operates.

### INDUSTRIAL APPLICABILITY

According to the insulation resistance monitoring apparatus of one aspect of the present invention, in the insulation resistance monitoring apparatus provided with the switch for opening and closing the circuit between the object to be measured and the internal voltage source, it is possible to determine whether or not the switch normally operates.

### REFERENCE SIGNS LIST

10: THREE-PHASE AC POWER SUPPLY APPARATUS
11 to 13: SINGLE-PHASE AC POWER SOURCE
20: CIRCUIT BREAKER
21 to 23: SWITCH
30: THREE-PHASE MOTOR APPARATUS
31 to 33: WINDING
34: HOUSING
35: LINE-TO-GROUND CAPACITANCE
36: LINE-TO-GROUND INSULATION RESISTANCE
40: INSULATION RESISTANCE MONITORING APPARATUS
41: CURRENT MEASURING DEVICE
42: CURRENT MEASURING DEVICE
43: CONTROLLER
44: DISPLAY DEVICE
E1: VOLTAGE SOURCE
SW: SWITCH

## Claims

1. An insulation resistance monitoring apparatus for monitoring an insulation resistance of an object to be measured, the insulation resistance monitoring apparatus comprising:
a voltage source configured to apply a voltage between two nodes of the object to be measured, the two nodes being insulated from each other;
a first current measuring device configured to measure a capacitive leakage current between the two nodes of the object to be measured;
a switch configured to open and close a circuit between the object to be measured and the voltage source; and
a controller configured to determine whether or not the switch normally operates, based on the measured capacitive leakage current.

2. The insulation resistance monitoring apparatus as claimed in claim 1,
wherein, when the measured capacitive leakage current increases to exceed a threshold immediately after turning on the switch, and decreases below the threshold within a predetermined time period after exceeding the threshold, the controller is further configured to determine that the switch normally operates, and
wherein, when the measured capacitive leakage current does not exceed the threshold immediately after turning on the switch, the controller is further configured to determine that the switch malfunctions.

3. The insulation resistance monitoring apparatus as claimed in claim 2,
wherein, when an event that the measured capacitive leakage current does not exceed the threshold immediately after turning on the switch occurs consecutively for a predetermined number of times, the controller is further configured to determine that the switch malfunctions.

4. The insulation resistance monitoring apparatus as claimed in any one of claims 1 to 3,
wherein the controller is further configured to stop calculation of the insulation resistance of the object to be measured, when determining that the switch malfunctions.

5. The insulation resistance monitoring apparatus as claimed in any one of claims 1 to 4,
wherein the switch has an open resistance of 100 megohms or more.

6. The insulation resistance monitoring apparatus as claimed in any one of claims 1 to 5,
wherein the two nodes of the object to be measured includes a first node connected to a power line of the object to be measured, and a second node connected to a ground conductor.

7. The insulation resistance monitoring apparatus as claimed in any one of claims 1 to 6, further comprising a second current measuring device configured to measure a resistive leakage current between the two nodes of the object to be measured,
wherein the controller calculates an insulation resistance of the object to be measured, based on the measured resistive leakage current.

8. The insulation resistance monitoring apparatus as claimed in claim 7, further comprising an output device configured to provide notification of the insulation resistance of the object to be measured, and whether or not the switch normally operates.
